# EUROPEAN PATENT SPECIFICATION

(11) **EP 0 596 474 B1**
(45) Date of publication and mention of the grant of the patent: **04.03.1998**
(21) Application number: 93117822.2
(22) Date of filing: 03.11.1993
(51) Int. Cl.: H03K 17/08

(54) **Circuit arrangement for controlled switch-off of a metal-oxide semiconductor field effect transistor**
Schaltungsanordnung zum kontrollierten Abschalten eines MOS-Feldeffekttransistors
Montage servant au blocage contrôlé d'un transistor à effet de champ du type MOS

(30) Priority: 03.11.1992 DE 4237119
(43) Date of publication of application: 11.05.1994
(73) Proprietor: TEXAS INSTRUMENTS DEUTSCHLAND GMBH, 85356 Freising (DE)
(72) Inventor: Bayer, Erich, D-84030 Landshut-Piflas (DE)
(74) Representative: Schwepfinger, Karl-Heinz, Dipl.-Ing.

(56) References cited:
- DE-A- 4 012 382
- DE-B- 1 229 140
- US-A- 4 504 779

## Description

The invention relates to a circuit arrangement for controlled switch-off of a metal-oxide semiconductor (MOS) field-effect transistor assigned to the feed circuit of an electrical load, serving particularly as a low-side driver and including an overcurrent detection means and a discharge circuit which is interposed between the gate terminal and the source terminal of the MOS field-effect transistor and which is gate-controllable by the overcurrent detection means for discharging a charge stored in the gate source capacitance in accordance with a predefinable time constant in an overcurrent condition.

In circuit arrangements of this kind the MOS field-effect transistors are protected from overcurrents, particularly short-circuit currents, by arranging for any such overcurrents to be detected and the power transistor concerned to be switched off. The object of this is to prevent the MOS field-effect transistor from being ruined by thermal overload.

As a rule, the required switch-off is achieved by a simple switch for short-circuiting the gate-source circuit of the MOS field-effect transistor so that discharge of the gate-source capacitance is achieved as quickly as possible.

This fast switch-off (hard OFF) causes a quick change in the gate potential which due to, for instance, possible inductance in the feeder lines may result in a considerable increase in voltage.

It has, therefore, been proposed to discharge the gate-source capacitance of the MOS field-effect transistor in the case of a short-circuit via a discharge circuit, the time constant of which is selected so that the voltage increase is maintained below a critical limit.

This circuit arrangement has the disadvantage, however, that the short-circuit current continues to increase during the actual switch-off action any may even attain values, by the time switch-off is complete, which may amount to a multiple more than the value measured just before switch-off was triggered. Under these circumstances the short-circuit currents may attain values as high as, for example, 100 A, especially in the case of MOS field-effect transistors having a low switch-on resistance and sources having a low internal impedance.

In US-A-4 504 779 a circuit for varying the power supplied from a D.C. power supply to a moderate to high power load such as a motor is disclosed. Trapezoidal voltage and current waveforms are used approaching the maximum load power delivery available from sine wave drives and the minimum dissipation in the driver circuitry available with square wave drives. The trapezoidal waveform drive is generated by controlling the voltages and current at the high impedance input of a MOS field effect transistor.

The controlled switch-off of the MOS field effect transistor includes a discharge circuit between the gate and the source. The charge stored in the gate source capacitance is discharged in a first discharge path with a very short time constant when the gate-source voltage is in an upper voltage range, in which there is practically no change of drain-source resistance with a change of gate-source voltage and in a second, separate discharge path comprising a constant current source and having a long time constant for a lower voltage range in which the drain-source resistance changes with the gate-source voltage.

From the DE-A-40 12 382 a circuit arrangement for switch-off of a power MOSFET is known which comprises an overcurrent detection means and two separately driveable discharge circuits. In the case of a short circuit, the gate voltage is lowered by voltage division before the power MOSFET is switched off.

The object of the invention is to provide, especially in the The object of the invention is to provide, especially in the case of a low-side driver, a circuit arrangement of the aforementioned kind which is exceptionally simple to realize in which the time span, in which an uncontrolled short-circuit current may flow, is reduced to a minimum and which, at the same time, ensures a reliable switch-off in the absence of voltage increases constituting a hazard to the power transistor.

This object is achieved according to the invention by the features of the precharacterizing past of claim 1.

Due to this configuration an extremly reliable protective circuit is provided which particularly in the case of a low-side driver can be realized by the simplest means and with which the switch-off and discharge behaviour as a function of the gate-source voltage profile is divided into a sequence of time periods which the first, whilst the drain-source resistance remains practically unchanged, is quickly passed through and the second period, during which the actual change in resistance occurs, is extended.

After the first switch-off or dischange period directly following undercurrent detection is passed through as quickly as possible, the time span in which the resulting over current or short-circuit current can practially not be controlled, is reduced to a minimum. Although the resulting change in the gate-source voltage during this first switch-off or discharge period at at a maximum, practically no change in the current occurs in the feeder circuit due to the changes in the drain-source resistance being so slight that they can be ignored, so that despite this period being passed through quickly, no increases in voltages whatsoever, for instance due to line inductances, are to be feared. As compared to this, the time duration of the second period of the switch-off or discharge action is extended to such an extent that the occurrence of voltage peaks endangering the MOS field-effect transistors is safely eliminated, despite the large changes in resistance.

The transition in time from the first to the second period of the switch-off or discharge action is substantially defined by the instant at which the gate-source voltage has achieved such a value that the drain-source resistance increases perceptibly as a function of the gate-source voltage. Entry into the second period of the switch-off or discharge action is preferably timed to follow slightly before this transition voltage being reached, i.e. already when the gate-source voltage is slightly above this transition voltage. In this way a high degree of safield-effect transistory is achieved, without having to accept an appreciable loss in time as regards the switch-off action.

The exceptionally simple circuit according to the invention can be employed to Special advantage in the case of a low-side driver or a source circuit, whereby the discharge circuit is usefully connected directly to the gate and source terminals of the MOS field-effect transistor. The forward voltage of the diode arrangement is thus to be selected essentially the same as the gate-source transition voltage located between the upper and the lower voltage ranges. As long as the gate-source voltage is located above the transition voltage or in the upper voltage range the diode arrangement is conducting so that the ohmic resistance in parallel to it is bypassed and discharge of the gate-source capacitance via the diodes and of a switch which is usefully closed via the overcurrent detection means is affected as quickly as possible. As soon as the gate-source voltage is smaller than the forward voltage of the diode arrangement or enters the lower voltage range, the diode arrangement reverses so that the gate-source capacitance is subsequently discharged via the ohmic resistor and the switch. In this case a significantly higher time constant results, as determined by the values of the gate-source capacitance and by the ohmic resistance.

Further advantageous embodiments of the invention are claimed in the subclaims.

The invention will now be described in more detail on the basis of an example embodiment with reference to the drawing in which:
- Fig. 1: represents the feed circuit of an electric load including a conventional circuit arrangement for switching off a metal-oxide semiconductor field-effect transistor included in the feeder circuit,
- Fig. 2: illustrates the circuit principle of a circuit arrangement according to the invention assigned to the feeder circuit according to Fig. 1 for for switching off a metal-oxide semiconductor field-effect transistor included in the feeder circuit,
- Fig. 3: is a graph representing the values of the drain-source resistance of the metal-oxide semiconductor field-effect transistor located in the feeder circuit according to Fig. 2 as a function of its gate-source voltage, and
- Fig. 4: shows the time profile of the gate voltage during switch-off or discharge of the metal-oxide semiconductor field-effect transistor produced by the circuit arrangement according to the invention.

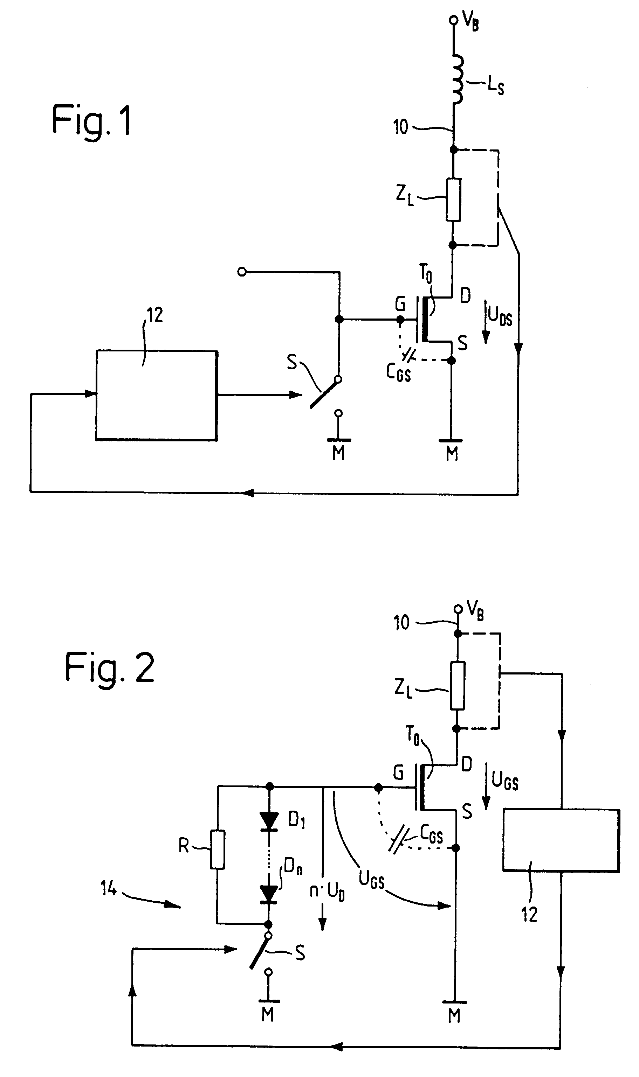

Fig. 1 illustrates the feeder circuit 10 for an electric load Z_{L} in series with a metal-oxide semiconductor field-effect transistor Tₒ which is assigned a conventional switch-off device for an emergency switch-off in case of a short circuit.

The drain terminal D of the MOS field-effect transistor Tₒ is connected via the electric load Z_{L} to the positive supply voltage terminal V_{B} whilst its source terminal S is at ground potential. The MOS field-effect transistor Tₒ is thus employed as a low-side driver (LSD) in a source circuit. The line inductance of the feed circuit 10 is indicated by L_{S}.

This conventional switch-off device comprises an electronic switch S interposed between the gate terminal G of the MOS field-effect transistor Tₒ and ground M and the source terminal S of the MOS field-effect transistor respectively and can be signalled via an overcurrent detection means 12 via which the switch S is closed as soon as a short circuit indicated by the dotted lines is detected, for instance, in the voltage drop across the load Z_{L}.

When the switch S is then closed due to a short circuit occurring in the feeder circuit 10, the gate terminal of the MOS field-effect transistor is placed at ground potential, resulting in the gate-source capacitance C_{GS} being short-circuited and thus discharged with minimum delay.

Due to such a quick switch-off of the MOS field-effect transistor Tₒ a correspondingly quick change in the drain-source resistance and drain-source voltage U_{DS} respectively occurs which due to the line inductance L_{S} may lead to voltage spikes which exceed the supply voltage V_{S} by a multiple thereof. The overvoltages resulting at the drain terminal of the MOS field-effect transistor Tₒ may cause in particular an avalanche breakdown of the MOS field-effect transistor Tₒ and, therefore, this conventional switch-off device by no means eliminates the possibility of the transistor being ruined.

Fig. 2 shows the circuit principle of an example embodiment of the circuit arrangement according to the invention for controlled switch-off of a metal-oxide semiconductor field-effect transistor Tₒ, i.e. again a power transistor which serves as a low-side driver in a feed circuit 10 for an electric load Z_{L} is interposed between the drain terminal D of the MOS field-effect transistor Tₒ and the positive voltage supply terminal V_{B} to ground (M). Here, the electric load Z_{L} is in turn input by a common source. In this case, however, the line inductance which is always involved, is not shown.

A discharge circuit 14 which can be switched between the gate terminal G of the MOS field-effect transistor Tₒ and ground (M) comprises a parallel circuit of an ohmic resistor R and a series arrangement of several diodes D₁ - Dₙ circuited in series with an electronic switch S.

This electronic switch S can be signalled via an overcurrent detection means 12 by means of which the feeder circuit 10 containing the MOS field-effect transistor Tₒ is monitored for possible short-circuit currents, by e.g. sensing the voltage drop across the load Z_{L}.

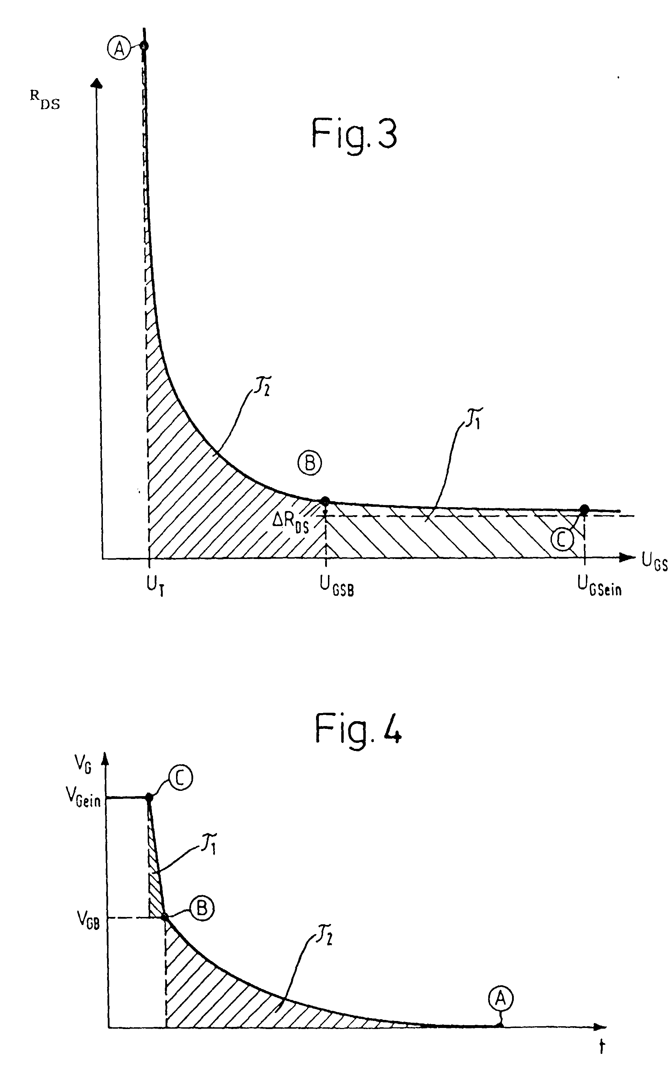

The overcurrent detector means 12 is designed in such a way that the switch S is closed as soon as a short-circuit indicated by the dashed lines occurs. The forward voltage n. U_{D} of the diode arrangement D₁ - Dₙ is selected so that i corresponds to a transition value U_{GSB} of the gate-source voltage U_{GS} which is located between an upper voltage range B - C, in which there is practically no change of the drain-source resistance R_{DS} with the gate-source voltage, and a lower voltage range A-B in which the drain-source resistance R_{DS} changes with the gate-source voltage (viz. Fig. 3). Accordingly, the number of diodes D₁-Dₙ exhibiting in each case a forward voltage U_{D} is to be selected corresponding to the transition voltage U_{GSB} so that when the switch S is closed, this diode arrangement D₁-Dₙ is first conducting at higher gate-source voltages U_{GS}, but reverses in due time before there is any perceptible increase in the drain-source resistance R_{DS} with increasing gate-source voltage U_{GS} (viz. Fig. 3). Such an increase in the drain-source resistance R_{DS} can be sensed according to Fig. 3 e.g. in the area of the point B on the resistance curve, at which the gate-source voltage U_{GS} assumes the transition value U_{GSB} which is located between the upper voltage range B-C and the lower voltage range A-B.

Point C on the characteristic of the drain-source resistance R_{DS} shown in Fig. 3 corresponds to the gate-source switch-on voltage U_{GSein} , whilst point A on the resistance characteristic is attained at the threshold voltage U_{T} at which the MOS field-effect transistor Tₒ is OFF or the drain-source resistance R_{DS} assumes its high value.

It can also be seen from the graph in Fig. 3 that the R_{DS} characteristic is, at first, substantially horizontal in a relatively large voltage range C-B, this meaning that there is practically no change of the drain-source resistance R_{DS} in this range with the reduction of the gate-source voltage U_{GS} during switch-off.

By contrast the drain-source resistance R_{DS} sharply increases, particularly in the last section of the lower voltage range B-A, to finally achieve at point A its highest value corresponding to the OFF condition.

The dashed horizontal line represents the asymptote approximated by the resistance characteristic for high values of the gate-source voltages U_{GS}. As can be seen from the graph, the deviation DR_{DS} with respect to the asymptotes is still so small as to be negligable.

To further enhance safe switching the transition voltage U_{GSB} , at which the diode arrangement D₁ - Dₙ begins to reverse, may be preferably shifted somewhat further in the direction of higher gate-source voltages U_{GS}, resulting in a small spacing from the point B on the resistance characteristic. In general the difference between the gate-source ON voltage U_{GSein} and the transition voltage U_{GSB} should always be as large as possible. At the same time the resulting deviation DR_{DS} of the transition voltage U_{GSB} from the asymptotes shown by the dashed lines should be as small as possible.

The function of the example embodiment of the circuit arrangement according to the invention shown in Fig. 2 is as follows:

As soon as the overcurrent detection means 12 detects an overcurrent, particularly a short circuit, switch S of the discharge circuit 14 is closed by the overcurrent detection means 12, thus placing the parallel arrangement of the resistor R and the diode arrangement D₁ - Dₙ between the gate terminal of the MOS field-effect transistor Tₒ and ground and the source terminal respectively and, therefore, parallel to the gate-source capacitance C_{GS}.

Since the gate-source voltage U_{GS} is initially still relatively high, i.e. higher than the forward voltage n · U_{D} of the diode arrangement D₁ - Dₙ, the latter is initially conducting after the electronic switch S is closed. The diode arrangement D₁ - Dₙ remains conducting until the gate-source voltage U_{GS} exceeds the transition value U_{GSB} (viz. Fig.3) or the threshold voltage n · U_{D} of the diode arrangement. This results in the gate-source capacitance, to span the relatively large, upper voltage range B - C, being discharged very quickly with a time constant t₁ in the region of zero.

As soon as the voltage drops below the transition voltage U_{GSB} or the forward voltage n.U_{D} of the diode arrangement D₁ - Dₙ so that the latter is OFF, the gate-source capacitance C_{GS} is no longer discharged via the diode arrangement , but instead through the resistor R. In the relatively small lower voltage range B - A which nevertheless results in a significant change in resistance, the gate-source capacitance C_{GS} is accordingly discharged with a significantly higher time constant t₂ as determined by the values of the gate-source capacitance C_{GS} and the ohmic resistor R.

Fig. 4 shows the time profile of the gate voltage V_{G} during the switch-off and/or discharge action, according to which the gate voltage V_{G} in the upper voltage range C - B drops very quickly from the ON voltage U_{Gein} to the transition voltage V_{GB} whilst in the lower voltage range B - A the gate voltage V_{G} sinks relatively slowly to the value zero from the transition value V_{GB} .

Time constant t₁, which during the initial switch-off phase is significantly shorter than t₂ to span the upper voltage range C - B, minimizes the time span in which the short-circuit current cannot be controlled. Since there is practically no change in the drain-source resistance R_{DS} during this initial switch-off phase no overvoltages due to line inductance L_{S} (viz. Fig. 1) can occur, despite the very quick discharge. The MOS field-effect transistor Tₒ thus has optimum protection in any phase of the switch-off action.

Since the threshold voltage U_{T} of the MOS field-effect transistor Tₒ and the forward voltages U_{D} of the diodes D₁ - Dₙ have a temperature coefficient of the same polarity a relatively stable switching point is ensured.

## Claims

1. A circuit arrangement for controlled switch-off of a metal-oxide circuit semiconductor (MOS) field-effect transistor (To) assigned to the feed circuit (10) of an electrical load (Z_{L}) serving particularly as a low-side driver (LSD) and including an overcurrent detection means (12) and a discharge circuit (14) between the gate terminal (G) and the source terminal (S) of said MOS field-effect transistor (To) for control by said overcurrent detection means (12) for discharging a charge stored in the gate source capacitance (C_{GS}) in accordance with a predefinable time constant (t) in an overcurrent condition, **characterized in that** said time constant (t) predefinable by said discharge circuit (14) is switchable between two different values as soon as said MOS field-effect transistor (To) exhibits a gate-source voltage (U_{GSB}) located between an upper voltage range (B - C), in which there is practically no change of drain-source resistance (R_{DS}) with a change of gate-source voltage (U_{GS}), and a lower voltage range (A-B) in which said drain-source resistance (R_{DS}) changes with said gate-source voltage (U_{GS}) and in that said time constant (t) has a relatively low value (t₁) as long as said gate-source voltage (UGS) is located in said upper voltage range (B-C), and assumes a relatively high value (t₂) as soon as said gate-source voltage (U_{GS}) is located in said lower voltage range (A-B), said discharge circuit (14) being switchable via an electronic switch (S) controlled by said overcurrent detection means (12) and interposed between the gate terminal (G) and the source terminal (S) of said MOS field-effect transistor (T₀), said discharge circuit (14) comprising a parallel circuit of a resistor arrangement having at least one ohmic resistor (R) and of a diode arrangement of one or more diodes connected in series (D₁ - Dₙ).

2. A circuit arrangement according to claim 1, **characterized in that** said time constant (t) predefinable by said discharge circuit (14) has a value (t₁) in the region of zero for gate-source voltages (U_{SG}) located in said upper voltage range (B-C).

3. A circuit arrangement according any of the preceeding claims, **characterized in that** the forward voltage (n · U_{D}) of said diode arrangement (D₁ - Dₙ) is selected as a function of said gate-source voltage (U_{GSB}) located between the upper (B-C) and lower (A-B) voltage ranges.

4. A circuit arrangement according to any of the above claims, **characterized in that** said MOS field-effect transistor (T₀) in a source circuit is connected to said electrical load (Z_{L}).

5. A circuit arrangement according to claim 4, **characterized in that** said resistor arrangement (R) and said parallel diode arrangement (D₁ - Dₙ) of said discharge circuit (14) are connected by said overcurrent detection means (12) directly to said gate terminal (G) and said source terminal (S) of said MOS field-effect transistor (Tφ) and in that said forward voltage (n · U_{D}) of said diode arrangement (D₁ - Dₙ) is selected equal to said gate-source voltage (U_{GSB}) located between the upper and lower voltage ranges (B - C and A - B respectively).

6. A circuit arrangement according to claim 5, **characterized in that** said overcurrent detection means (12) is a short-circuit detector means.

## Patentansprüche

1. Schaltungsanordnung zum kontrollierten Abschalten eines dem Speisekreis (10) einer elektrischen Last (Z_{L}) zugeordneten, insbesondere als Low-Side-Treiber (LSD) dienenden Metalloxid-Halbleiter (MOS)-Feldeffekttransistors (T₀), mit einer Überstrom-Erfassungseinrichtung (12) und einem zwischen den Gate-Anschluß (G) und den Source-Anschluß (S) des MOS-Feldeffekttransistors (T₀) geschalteten, durch die Überstrom-Erfassungseinrichtung (12) ansteuerbaren Entladestromkreis (14), über den im Überstromfall die in der Gate-Source-Kapazität (C_{GS}) gespeicherte Ladung entsprechend einer vorgebbaren Zeitkonstante (t) abführbar ist, **dadurch gekennzeichnet**, daß die durch den Entladestromkreis (14) vorgebbare Zeitkonstante (t) zwischen zwei unterschiedlichen Werten umschaltbar ist, sobald der MOS-Feldeffekttransistor (T₀) eine Gate-Source-Spannung (U_{GSB}) aufweist, die zwischen einem oberen Spannungsbereich (B - C), in dem sich der Drain-Source-Widerstand (R_{DS}) praktisch nicht mit der Gate-Source-Spannung (U_{GS}) ändert, und einem unteren Spannungsbereich (A - C) liegt, in dem sich der Drain-Source-Widerstand (R_{DS}) mit der Gate-Source-Spannung (U_{GS}) ändert, und daß die Zeitkonstante (t) einen relativ kleinen Wert (t₁) besitzt, solange die Gate-Source-Spannung (U_{GS}) in dem oberen Spannungsbereich (B - C) liegt, und einen relativ großen Wert (t₂) annimmt, sobald die Gate-Source-Spannung (U_{GS}) in dem unteren Spannungsbereich (A - C) liegt, wobei der Entladestromkreis (14) über einen von der Überstrom-Erfassungseinrichtung (12) angesteuerten elektronischen Schalter (S) zwischen den Gate-Anschluß (G) und den Source-Anschluß (S) des MOS-Feldeffkttransistors (T₀) schaltbar ist und der Entladestromkreis (14) eine Parallelschaltung aus einer Widerstandsanordnung mit wenigstens einem ohmschen Widerstand (R) und einer Diodenanordnung aus einer oder mehreren in Reihe geschalteten Dioden (D₁ -Dₙ) umfaßt.

2. Schaltungsanordnung nach Anspruch 1, **dadurch gekennzeichnet**, daß die durch den Enladestromkreis (14) vorgebbare Zeitkonstante (t) bei im oberen Spannungsbereich (B - C) liegenden Gate-Source-Spannungen (U_{GS}) einen Wert (t₁) im Bereich von Null besitzt.

3. Schaltungsanordnung nach einem der vorhergehenden Ansprüche, **dadurch gekennzeichnet**, daß die Durchlaßspannung (n · U_{D}) der Diodenanordnung (D₁ - Dₙ) in Abhängigkeit von der zwischen dem oberen und dem unteren Spannungsbereich (B - C bzw. A - B) liegenden Gate-Source-Spannung (U_{GSB}) gewählt ist.

4. Schaltungsanordnung nach einem der vorhergehenden Ansprüche, **dadurch gekennzeichnet**, daß der MOS-Feldeffekttransistor (T₀) in einer Source-Schaltung mit der elektrischen Last (Z_{L}) verbunden ist.

5. Schaltungsanordnung nach Anspruch 4, **dadurch gekennzeichnet**, daß der die Widerstandsanordnung (R) und die dazu parallele Diodenanordnung (D₁-Dₙ) umfassende Entladestromkreis (14) durch die Überstrom-Erfassungseinrichtung (12) unmittelbar mit dem Gate-Anschluß (G) und dem Source-Anschluß (S) des MOS-Feldeffekttransistors (T₀) verbunden ist und daß die Durchlaßspannung (n · U_{D}) der Diodenanordnung (D₁-Dₙ) gleich der zwischen dem oberen und dem unteren Spannungsbereich (B - C bzw. A - B) liegenden Gate-Source-Spannung (U_{GSB}) gewählt ist.

6. Schaltungsanordnung nach Anspruch 5, **dadurch gekennzeichnet,** daß die Überstrom-Erfassungseinrichtung (12) eine Kurzschlußstrom-Erfassungseinrichtung ist.

## Revendications

1. Agencement de circuit pour commander le blocage d'un transistor à effet de champ (T₀) à métal-oxyde-semiconducteur (MOS) attribué au circuit d'alimentation (10) d'une charge électrique (Z_{L}) servant particulièrement comme un dispositif de pilotage de côté bas (LSD) et comprenant des moyens de détection de surintensité (12) et un circuit de décharge (14) entre la borne de grille (G) et la borne de source (S) dudit transistor à effet de champ MOS (T₀) pour une commande par lesdits moyens de détection de surintensité (12) pour décharger une charge stockée dans la capacité source-grille (C_{GS}) selon une constante de temps prédéterminable (t) dans une condition de surintensité, caractérisé en ce que ladite constante de temps (t) prédéterminable par ledit circuit de décharge (14) est commutable entre deux valeurs différentes dès que ledit transistor à effet de champ MOS (T₀) présente une tension source-grille (U_{GSB}) située entre une plage de tension supérieure (B-C), dans laquelle il n'y a pratiquement aucune variation de la résistance drain-source (R_{DS}) avec une variation de la tension source-grille (U_{GS}) et une plage de tension inférieure (A-B) dans laquelle ladite résistance source-drain (R_{DS}) change avec ladite tension source-grille (U_{GS}) et en ce que ladite constante de temps (t) a une valeur relativement basse (t1) tant que ladite tension source-grille (U_{GS}) est située dans ladite plage de tension supérieure (B-C), et prend une valeur relativement haute (t₂) dès que ladite tension source-grille (U_{GS}) est située dans ladite plage de tension inférieure (A-B), ledit circuit de décharge (14) étant commutable à travers un commutateur électronique (S) commandé par lesdits moyens de détection de surintensité (12) et interposé entre la borne de grille (G) et la borne de source (S) dudit transistor à effet de champ MOS (T₀), ledit circuit de décharge (14) comprenant un circuit parallèle d'un agencement de résistance ayant au moins une résistance ohmique (R) et d'un agencement de diode d'une ou de plusieurs diodes connectées en série (D₁ - Dₙ).

2. Agencement de circuit selon la revendication 1, caractérisé en ce que ladite constante de temps (t) prédéterminable par ledit circuit de décharge (14) a une valeur (t₁) proche de zéro pour des tensions source-grille (U_{SG}) situées dans ladite plage de tension supérieure (B-C).

3. Agencement de circuit selon l'une quelconque des revendications précédentes, caractérisé en ce que la tension directe (n.U_{D}) dudit agencement de diode (D₁-Dₙ) est sélectionnée comme une fonction de ladite tension source-grille (U_{GSB}) située entre les plages de tension supérieure (B-C) et inférieure (A-B).

4. Agencement de circuit selon l'une quelconque des revendications précédentes, caractérisé en ce que ledit transistor à effet de champ MOS (T₀) dans un circuit de source est connecté à ladite charge électrique (Z_{L}).

5. Agencement de circuit selon la revendication 4, caractérisé en ce que ledit agencement de résistance (R) et ledit agencement de diode en parallèle (D₁-Dₙ) dudit circuit de décharge (14) sont connectés par lesdits moyens de détection de surintensité (12) directement à ladite borne de grille (G) et ladite borne de source (S) dudit transistor à effet de champ MOS (T₀) et en ce que ladite tension directe (n.U_{D}) dudit agencement de diode (D₁-Dₙ) est choisie égale à ladite tension de source-grille (U_{GSB}) située entre les plages de tension supérieure et inférieure (B-C et A-B respectivement).

6. Agencement de circuit selon la revendication 5, caractérisé en ce que lesdits moyens de détection de surintensité (12) comprennent des moyens de détection d'un court-circuit.
